# EUROPEAN PATENT SPECIFICATION

(11) **EP 2 328 841 B1**
(45) Date of publication and mention of the grant of the patent: **06.04.2016**
(21) Application number: 09814122.9
(22) Date of filing: 18.09.2009
(51) Int. Cl.: C01F 11/00, C01F 11/18, C03C 1/02

(54) **MANUFACTURE OF A MATERIAL ON THE BASIS OF CALCIUM- AND/OR MAGNESIUM CARBONATE HAVING A REDUCED DECREPITATION TENDENCY**
HERSTELLUNG EINES MATERIALS AUF CALCIUM- UND/ODER MAGNESIUMCARBONATBASIS MIT VERRINGERTER DEKREPITATIONSTENDENZ
FABRICATION D'UN MATÉRIAU À BASE DE CARBONATE DE CALCIUM ET/OU DE CARBONATE DE MAGNÉSIUM AYANT UNE TENDANCE À LA DÉCRÉPITATION RÉDUITE

(30) Priority: 18.09.2008 EP 08105381
(43) Date of publication of application: 08.06.2011
(73) Proprietor: Rheinkalk GmbH, 42489 Wülfrath (DE)
(72) Inventor: PICKBRENNER, Arnd, 42579 Heiligenhaus (DE); ROHMANN, Matthias, 37441 Bad Sachsa (DE); PUST, Christopher, 40625 Düsseldorf (DE); LORGOUILLOUX, Marion, B-1310 La Hulpe (BE); PELLETIER, Marc, F-94160 Saint Mandé (FR)
(74) Representative: Cohausz & Florack
(86) International application number: PCT/EP2009/062107
(87) International publication number: WO 2010/031834

(56) References cited:
- DE-A1- 1 471 844
- DE-A1- 3 209 618
- DE-A1- 4 207 923
- US-A- 3 726 697
- D. DOLLIMORE ET AL.: "The decrepitation of dolomite and limestone" THERMOCHIMICA ACTA, vol. 237, 1994, pages 125-131, XP002517674 Amsterdam (NL) cited in the application

## Description

This invention relates to the manufacture of a material on the basis of calcium- and/or magnesium carbonate having a reduced decrepitation tendency. Further, the invention relates to a material on the basis of calcium- and/or magnesium carbonate having a reduced decrepitation tendency as well as to the use of such material for the manufacture of glass, in particular soda-lime-glass or float-glass.

Generally, decrepitation is considered as bursting apart of inorganic crystal lattices if subjected to elevated temperatures. There are a number of inorganic materials which tend to decrepitate. The present invention relates to the reduction of the decrepitation tendency of a material on the basis of calcium- and/or magnesium carbonate, preferably calcium- and/or magnesium carbonate, and in particular dolomite and limestone.

The decrepitation tendency of materials comprising calcium- and/or magnesium carbonate is disadvantageous from technical reasons since calcium- and/or magnesium carbonate is an important raw material, in particular for the manufacture of glass. During the manufacture of glass, temperatures of more than 1,400°C are achieved. At these temperatures, usually, a part of the calcium- and/or magnesium carbonate breaks decrepitatively before melting, which leads to a number of disadvantages.

The decrepitation of calcium- and/or magnesium carbonate, in particular during the manufacture of glass, is unwanted since it is accompanied by increased formation of dust. For several reasons the formation of dust is disadvantageous for the manufacture of glass.

On the one hand, the dust forms an aerosol with the combustion gas, the so called carry over, and is thus removed from the melting process - which leads to a loss of material. On the other hand, the batch carry-over impurifies the recuperators/regenerators present in the heat exchanging device. This promotes plugging, decreases heat exchange and increases the efforts for cleaning of the devices.

Another disadvantage of the increased formation of dust by decrepitation, in particular during the manufacture of glass, is that the increased carry over of alkaline particles enhances the corrosion of the superstructure refractory, thereby lowering the glass furnaces lifetime. Additionally, many of the glass defects are caused by corrosion of the refractory, which also applies to the superstructures crown.

In order to reduce the decrepitation tendency of dolomite and limestone it has been suggested to thermally pretreat such material before use. In doing so the critical part of the material breaks decrepitatively before being thermally converted in the actual production process. Such an approach is disadvantageous since a supplemental heating step is necessary - which is unwanted due to environmental and economical reasons.

A further approach takes advantage of the fact that there is a connection between the primary particle size of the calcium- and/or magnesium carbonate used and their decrepitation tendency. In particular dolomite and limestone particles having a critical primary particle size of less than 1 mm show an increased decrepitation tendency. Even higher decrepitation tendencies may be observed in dolomite having a primary particle size of more than 90 µm, in particular more than 150 µm, and of less than 600 µm, in particular less than 500 µm. In limestone the most critical primary particle sizes are in general 150 to 1180 µm and in particular 425 to 850 µm. By reducing the amount of such critical primary particle size in the overall primary particle size distribution - for example by sieving or air-classifying - the decrepitation tendency of dolomite and/or limestone may be reduced. However, a serious disadvantage is that in general about 30 to 60 wt.% of raw dolomite particles used for the manufacture of glass show the above critical particle size. Thus, a high amount of raw dolomite is wasted, and this approach is not satisfactory, neither.

DE 1 920 202 A1 describes a process for the manufacture of inorganic glasses, especially soda-lime glasses using alkaline inorganic compositions which serve as a source for alkali metal oxides and alkaline earth metal oxides. In the process, a source for alkaline earth metal oxide, lime and/or dolomite reacts with an aqueous alkali metal hydroxide solution (Na(OH)). The amount of alkali metal hydroxide used is such that at least 50 wt.% of the total amount of alkali metal fluxing agent needed for the glass manufacture is provided. If the reaction product obtained in this process is used instead of the lime and/or dolomite usually used during the manufacture of glass, the tendency of the batch to decrepitate may be reduced.

An important feature of the above process is that only one raw material source needed for the glass manufacture is used. This raw material source already comprises calcium and sodium in an amount suited for the manufacture of glass. However, such an approach is disadvantageous since the use of a large amount of sodium metal hydroxide demands a considerable technical effort.

DE 24 59 840 describes a process for the manufacture of a batch in the form of pellets, in which all components of the glass batch are treated with a concentrated sodium hydroxide solution. The amount of the sodium hydroxide is adjusted such that the whole amount or at least the main amount of the sodium oxide necessary in the batch is provided by the sodium hydroxide as equivalent to sodium oxide. The pellets manufactured in this manner show a decreased tendency to release dust. A disadvantage of this process is again that a single raw material source and thus a large amount of sodium hydroxide is used.

The manufacture of the reaction products of calcium- and/or magnesium carbonate and sodium hydroxide as well as the use of these reaction products in the manufacture of glass is also described in documents DE 26 50 224 A1, US 3 726 697 and US 3 573 887. Disadvantageous of all these processes is that a high amount of sodium hydroxide is used.

DE 1 471 844 A1 describes the subjection of an admixture comprising a vitrifiable mass suitable for glass manufacture including a metal hydroxide to an atmosphere of an acid gas. The objective to be achieved by the process according to this document is to prevent the ingredients of the vitrifiable mass from segregating prior to melting.

DE 32 09 618 A1 describes a process for stabilizing pellets for agriculture and building construction consisting of pulverulent mineral materials, such as for example dolomite, or carbonate. Coating of a surface of the pellets or granulates with a layer of mineral, such as a dilute acid or alkali, which is at least partly insoluble prevents the entry of moisture or other components of the atmosphere into the pellet material so that the mechanical resistance and chemical stability of the material may be increased. This document does not describe that a reduced decrepitation tendency of the mineral materials may be achieved.

DE 42 08 068 A1 describes a method for granulating alkaline earth metal carbonate, especially barium carbonate and strontium carbonate, by adding a binding agent and optionally water, and granulating the carbonate material by the action of mechanical forces or by accretional granulation with simultaneous drying, and thereafter optionally subjecting the granules to a high-temperature treatment. As a binding agent alkali hydroxides or water glass may be used. The starting material is finely divided - because coming from a precipitation process - and is as such not susceptible for decrepitation. Accordingly, the process described in this document does not lead to a reduced decrepitation tendency of the starting material.

DE 42 07 923 A1 describes a method for granulating alkaline earth metal carbonate by granulating the alkaline earth metal carbonate in the presence of a binding agent and optionally water followed by an optional subsequent high temperature treatment.

The object underlying the present invention is to provide a process for reducing the decrepitation tendency of materials on the basis of calcium- and/or magnesium carbonate in an economical and ecological manner.

This object is achieved by a process for the manufacture of a material on the basis of calcium carbonate and/or magnesium carbonate having a reduced decrepitation tendency, wherein a material on the basis of calcium carbonate and/or magnesium carbonate comprising 20 to 80 wt.% of particles having a primary particle size of more than 90 µm and less than 1 mm is coated with at least one additive selected among alkali metal compounds, and/or alkaline earth metal compounds in an amount of 0.05 to 5 wt.% based on the amount of the material on the basis of calcium carbonate and/or magnesium carbonate wherein the alkaline earth metal compounds have a solubility at 25°C in water of at least 0.5%.

In the diction of the invention, material on the basis of calcium- and/or magnesium carbonate preferably means substances comprising calcium- and/or magnesium carbonate in an amount of more than 85 wt.%, preferably 90 wt.% to 99 wt.%, and most preferred 95 wt.% to 98 wt.%.

It was surprisingly found that the decrepitation tendency of a material on the basis of calcium- and/or magnesium carbonate, in particular dolomite, may effectively be reduced by the treatment with at least one additive selected among alkali metal compounds and/or alkaline earth metal compounds in an amount of as low as 0.05 to 5 wt.% based on the amount of the material on the basis of calcium- and/or magnesium carbonate.

Based on today's knowledge the mechanism for the reduction of decrepitation tendency in the process according to the invention may not be explained with certainty. Possible explanations involve the formation of a coating film and/or chemical reactions on the surface of the material. Most probably, the mechanism depends on the raw materials and conditions used.

According to a preferred embodiment of the invention, the treatment of the material on the basis of calcium- and/or magnesium carbonate involves coating the material with at least one additive selected among alkali metal compounds and/or alkaline earth metal compounds in an amount of 0.05 to 5 wt.% based on the amount of the material on the basis of calcium- and/or magnesium carbonate.

"Coating" in the diction of the invention is meant to include the formation of a coating film, possibly partial, containing the additive and/or reaction products thereof.

Another mechanism for the reduction of the decrepitation tendency of the material on the basis of calcium and/or magnesium carbonate with the additive treatment according to the present invention could also be a chemical reaction occuring between the additive and the material on the basis of calcium and/or magnesium carbonate. This reaction occurs likely at the surface of the particles of the material on the basis of calcium and/or magnesium carbonate and is supposed to influence the decarbonation kinetics of the material on the basis of calcium and/or magnesium carbonate when heated above 400 °C, perhaps through the formation of an intermediate liquid phase.

The material obtained by the process according to the invention may be heated nearly without any decrepitative break. If such material is used in the manufacture of glass, the problems usually linked with decrepitation may significantly be reduced. In particular, nearly or no significant decrepitative formation of dust takes place. This leads to an improved exploitation of raw material and in addition to less wear of the glass manufacture facilities.

In contrast to the state of the art, the alkali metal compound and/or the alkaline earth metal compound is not used as co-reagent but as additive. As compared with known processes, the process according to the invention is characterized by the fact that only small amounts of alkali metal compound and/or alkaline earth metal compound are necessary as treating agents to reduce the decrepitation tendency. Moreover, also solutions having a low concentration of additives may be used. In the process according to the invention the decrepitation tendency of calcium- and/or magnesium carbonate may selectively be reduced. Moreover, the process is more environmentally friendly, cost saving and the consumption of chemicals is low.

According to a preferred embodiment of the invention, the material on the basis of calcium- and/or magnesium carbonate is treated with at least one additive selected among alkali metal compounds and/or alkaline earth metal compounds in such an amount that the weight ratio of the additive to the material is 0.1 to 3 wt.%, more preferred 0.2 to 2 wt.%, and in particular 0.5 to 1.5 wt.%.

As already explained, a possible explanation for the reduction of decrepitation tendency observed in the process of the invention involves the formation of a film, even partial, on the surface of the material. In the case of a film formation - due to the small amount of additive used - the film thickness is preferably less than 5 µm, more preferably less than 2 µm and in particular less than 0.5 µm.

It was surprisingly found that the treatment according to the invention may be conducted at low temperatures. Practical assays have shown that in the process according to the invention already at temperatures as low as less than 100°C, preferably less than 60°C, preferably at 10°C to 50°C, more preferably at 20°C to 40°C and even at surrounding temperature, the decrepitation tendency of a material on the basis of calcium- and/or magnesium carbonate may effectively be reduced. The application of low temperatures is advantageous for economical and procedural reasons.

Principally, in the process according to the invention the decrepitation tendency of many materials on the basis of calcium- and/or magnesium carbonate may be reduced. A particularly huge reduction of decrepitation tendency may be observed in the treatment of dolomite and limestone.

As explained above, in particular materials having a primary particle size of more than 90 µm and less than 1 mm show a high decrepitation tendency. This is why the treatment of materials with a high amount of particles having a primary particle size of more than 90 µm and less than 1 mm has been shown to be especially effective. A particularly effective reduction of decrepitation tendency may be observed by the treatment of dolomite comprising 20 wt.% to 80 wt.%, preferably 30 wt.% to 80 wt.%, more preferably 40 wt.% to 70 wt.%, of particles having a primary particle size of more than 90 µm, in particular more than 150 µm, and less than 600 µm, preferably less than 500 µm and of limestone comprising 20 wt.% to 80 wt.%, preferably 30 wt.% to 80 wt.%, more preferably 40 wt.% to 70 wt.%, of particles having a primary particle size of 250 to 1180 µm and in particular 425 to 850 µm.

Fundamentally, the material may be treated with a large number of additives selected among alkali metal compounds and/or alkaline earth metal compounds. Particular good results are achieved with alkali metal compounds and/or alkaline earth metal compounds having a solubility at 25°C in water of at least 0.5%, preferably at least 5%, more preferred at least 25% and most preferred at least 50%. Practical experiments have shown that alkali metal compounds are particularly effective in reducing the decrepitation tendency of materials on the basis of calcium- and/or magnesium carbonate.

Particularly preferred as additives are hydroxides, carbonates, silicates, sulfates and/or halogenides, in particular of alkali metal compounds. Suited are also alkaline-earth metal hydroxides, sulfates and halogenides. Sodium hydroxide (NaOH), potassium hydroxide (KOH), magnesium hydroxide (Mg(OH)₂), sodium silicate (Na-silicate), potassium silicate (K-silicate), sodium sulfate (Na₂SO₄), sodium carbonate (Na₂CO₃), potassium carbonate (K₂CO₃), magnesium carbonate (MgCO₃), potassium sulfate (K₂SO₄), magnesium sulfate (MgSO₄), sodium chloride (NaCl), sodium bromide(NaBr), potassium bromide(KBr), calcium chloride

(CaCl₂), magnesium chloride (MgCl₂), potassium chloride (KCl) or mixtures thereof show good results. A large number of the aforementioned additives are characterized in that they do not negatively influence the manufacture of glass. For the manufacture of soda-lime glass particularly suited are NaOH, Na₂SO₄, Na₂CO₃ and/or Na-silicate. The material on the basis of calcium- and/or magnesium carbonate treated with the aforementioned additives may be used for the manufacture of glass without any problem.

The material on the basis of calcium- and/or magnesium carbonate may be treated with the additive by different manners. A particularly easy way is to contact the material with a solution and/or suspension containing the additive and a solvent. Practical assays have shown that very good treatment results are obtained if a solution or suspension containing the additive is applied to the material using effective mixing processes. In doing so a homogeneous surface treatment is provided. The solution may also be sprayed onto the material to be treated. Practical assays have shown that, preferably, the amount of the solution is such that the surface of the material to be treated is completely covered by the solution.

A preferred solvent is water. Water shows a high dissolving capacity and may in addition easily be removed.

In principle, there is no need for any additional drying step after the treatment. However, practical assays have shown that by performing a drying step, preferably at a temperature lower than 150°C and more preferably between 40°C and 110°C, particularly good results are obtained.

The amount of additive in the solvent may vary largely. Generally, the amount depends on the kind of additive and solvent used and in particular on the solubility of the additive in the solvent. It is preferred to use solutions, preferably on the basis of water, containing the alkali metal compound and/or the alkaline earth metal compound in an amount of 0.5 to 60 wt.%, preferably 5 to 60 wt.%, most preferably 25 to 50 wt.%.

In principle, solutions comprising additives in a wide range of saturation degrees may be used according to the invention. The use of higher concentrated solutions enhances the reactivity of the solution and is advantageous for the global handling of the product, in particular with view to logistic aspects. Moreover, the product is less sticky and contains less moisture which reduces the amount of drying energy required. On the other hand, solutions with a higher content of solvent lead to an easier homogenisation and a more consistent surface treatment.

According to a further preferred embodiment of the invention, the material on the basis of calcium- and/or magnesium carbonate is surface treated in an educed form. The feature "educed" in the diction of the invention means that the material is treated in the presence of only small amounts of or preferably in the absence of further batch components such as SiO₂. Preferably, the amount of the further batch components present is less than sixfold, preferably less than fivefold, even more preferably less than threefold, even more preferably less than the 100 wt.% and in particular less than 10 wt.% compared to the amount of the material on the basis of calcium- and/or magnesium carbonate. This procedure is particularly preferred since the amount of additive needed is very low and it prevents unwanted side reactions or unwanted additive consumption.

In the process according to the invention the decrepitation tendency of a material on the basis of calcium- and/or magnesium carbonate according to the Pilkington test may be reduced by at least about 10%, more preferably by 30% to 95%, more preferably by 40% to 90% and most preferred by 50% to 80%.

The details of the Pilkington test are further described in "Decrepitation of dolomite and limestone", Dollimore et al., Thermochimica Acta, 237, 1994, pp.125-131. The aforementioned reference is herewith incorporated by reference in respect of the determination of the decrepitation tendency according to Pilkington.

A further subject of the present invention relates to a material on the basis of calcium- and/or magnesium carbonate having a reduced decrepitation tendency and which may be manufactured in the process according to the invention.

A further subject of the present invention relates to a material on the basis of calcium- and/or magnesium carbonate comprising 20 wt.% to 80 wt.% of particles with a primary particle size of more than 90 µm, preferably more than 150 µm, and less than 1 mm, preferably less than 500 µm, the material being treated with at least one additive selected among alkali metal compounds and/or alkaline earth metal compounds and/or reaction products thereof and having a decrepitation tendency according to Pilkington of more than 0.1% and less than 10%, preferably 0.5 to 5%, most preferably 0.5% to 3%.

The material according to the invention may be defined over the state of the art by comprising sulfur in an amount of 0.07 to 3 wt.%, preferably 0.1 to 2.5 wt.%, more preferably 0.15 to 2 wt.%, and in particular 0.2 to 1.7 wt.%, and/or sodium in an amount of 0.04 to 4.5 wt.%, preferably 0.05 to 4 wt.%, more preferably 0.08 to 3.5 wt.%, and in particular of 0.1 to 2.9 wt.%, and/or potassium in an amount of 0.08 to 5 wt.%, preferably 0.1 to 4.5 wt.%, more preferably 0.15 to 4 wt.%, and in particular 0.2 to 3.5 wt.%, based on the material of calcium- and/or magnesium carbonate.

Thus, the material according to the invention is defined over the state of the art by the fact that it comprises in addition to the basis of calcium- and/or magnesium carbonate the additive which is the alkali metal compound and/or the alkaline earth metal compound and/or fragments and/or reaction products thereof.

The presence of these additional components may be observed for example by pH measurements. For instance, the material on the basis of calcium- and/or magnesium carbonate treated with sodium hydroxide and/or sodium carbonate in the process according to the invention usually has a pH value above 10, preferably above 10.5, and most preferably above 11. Moreover, the presence of the additive and/or fragments and/or reaction products thereof may be measured for example by X-Ray-Fluorescence (XRF), Atomic Absorption Spectroscopy (AAS) and/or Inductively Coupled Plasma (ICP).

The material is particularly suited for the manufacture of glass or float glass. Fundamentally, the process for the manufacture of glass is divided in several phases. First, the glass batch is mixed accurately. For the manufacture of soda-lime glass which represents about 90 wt.% of the amount of glass produced, for example the following raw materials are used for the glass batch.

Silica sand is a nearly pure SiO₂ carrier for the formation of the networks. A further component is sodium carbonate, which serves as fluxing aid and sodium oxide carrier.

A further important component of the batch is limestone and/or dolomite.

The batch may be added to the melting tank at temperatures of about 1,500°C. The rough melt is followed by the refining step to clear and homogenize the melt. Finally, the batch is moulded and cooled depending to the process.

The calcium- and/or magnesium carbonate material according to the invention is particularly suited for the use in the manufacturing process for glass. Preferably, the material according to the invention is mixed with the further batch components and melted.

In the following, the invention is further described by examples.

### 1. Examples 1 to 13: Determination of the decrepitation tendency of dolomite samples

### 1.1 General Procedure

In Examples 1 to 13 the following operating procedure is used.

Dolomite generally used in the glass industry is dried and separated to select the range of primary particle sizes between 90 µm and 500 µm. As explained above, dolomite having primary particle sizes between 90 µm and 500 µm are the most subject to decrepitation and are thus the fraction most sensitive for the Pilkington test.

The quantity of additive used is shown in column 2 of Table 1 (below) as weight percentage of dolomite to be treated. The additive is dispersed into 10 cm³ of water. The total amount of the solution thus formed is sprayed onto 100 g of dolomite (90/500 µm), placed in a bowl of a blade laboratory mixer. Subsequently, the dolomite is homogenised by mixing for 30 seconds. The homogenised dolomite is then removed from the mixer, placed onto a drying plate and finally dried in a drying furnace at 105°C for 3 hours.

The amount of water added to the dolomite together with the additive has been chosen to simultaneously allow homogeneous surface treatment and to limit the excess of liquid. In doing so the obtained product is not sticky.

### 1.2 Test Results

The test results are summarized in Table 1 below.

| **1** | **2** | **3** | **4** |
|---|---|---|---|
| **Example** | **Treating agent** | **Decrepitation in (%)** | **Decrepitation reduction** |
| 1 | - | 21.9 | Reference |
| 2 | 0.5% MgSO₄ | 19.7 | 10% |
| 3 | 0.5% Na₂SiO₃ | 19.7 | 10% |
| 5 | 0.5% Na₂SO₄ | 18.4 | 16% |
| 6 | 0.5% KOH | 17.9 | 18% |
| 7 | 0.5% NaOH | 17.9 | 18% |
| 8 | 0.5% Na₂CO₃ | 17.8 | 19% |
| 9 | 0.5% K₂CO3 | 17.5 | 20% |
| 10 | 0.5% NaCl | 17.8 | 19% |
| 12 | 0.5% KBr | 14.9 | 32% |
| 13 | 1.5% NaOH | 14.2 | 35% |

| | | | |
|---|---|---|---|
| Table 1 - Decrepitation tests on Dolomite (90 to 500 µm) | | | |

Column 3 of Table 1 shows the decrepitation value of Examples 1 to 13 determined using the Pilkington test.

Example 1 indicates the decrepitation value of raw dolomite not treated in the process according to the invention. Example 1 is used as reference to compute the decrepitation reduction shown in column 4.

Examples 2 to 13 show the decrepitation value of raw dolomite treated in the process according to the invention. In examples 2 to 13 eleven different treating agents are used.

Except for example 13, the treating agent is added in an amount corresponding to 0.5 wt.% of the raw dolomite. The results (column 4) show that in all examples 2 to 13 the decrepitation tendency is reduced by at least 10% as compared to the reference.

In example 13, the amount of treating agent (NaOH) corresponds to 1.5 wt.% of the raw dolomite. Comparing examples 7 and 13 indicates the effect of increasing the amount of the treating agent used on the reduction of the decrepitation value (column 4).

### 2. Examples 14 to 17: Determination of the decrepitation tendency of entire dolomite samples

### 2.1 General procedure

Dolomite "0-2 mm" sand usually used in the glass industry is separated in charges of 800 to 1200 g each assay by sample division and added to a laboratory mixer. Then, an additive solution containing 10 wt.% of an alkali metal compound is added drop-wise to the running mixer. Subsequently, the mixture is mixed for about five minutes at an average rotational speed. The humid sample is then removed from the mixer, placed onto a drying plate and dried at 105°C in the drying furnace until the weight of the sample does no more change (about 12-24 h). The sample thereby obtained is tested for its decrepitation tendency using the Pilkington test (see above). Table 2 shows the decrepitation tendency of the different samples determined using the Pilkington test. In contrast to examples 1 to 13, the entire fraction 0 to 2 mm of raw dolomite is used.

### 2.2 Test results

**Table 2 Decrepitation tests on dolomite (0-2 mm)**

| | **Dolomite 0-2 mm (g)** | **10 wt % NaOH solution (g)** | **10 wt % Na₂SiO₃ solution (g)** | **Additional water (g)** | **% of additve relative** to | **Decrepitation Pilkington (%)** | **Decrepitation reduction (%)** |
|---|---|---|---|---|---|---|---|
| **14** | 850 | 42.5 | - | - | 0.5 | 4.5 | 51 |
| **15** | 826 | - | 41.5 | - | 0.5 | 5.2 | 44 |
| **16** | 1229 | - | - | 55.0 | - | 9.0 | 2 |
| **17** | 1000 | - | - | - | - | 9.2 | - |

Example 17 is the reference (non-treated dolomite). By comparison, example 16 shows no influence of water alone.

Example 14 concerning the treatment with sodium hydroxide shows a greater influence on decrepitation tendency than example 15, treated with sodium silicate.

### 3. Example 18: Industrial scale treatment

At the laboratory scale, the experiments above show that the treatment of raw dolomite with at least one additive selected among alkali metal compounds and/or alkaline earth metal compounds according to the invention has a positive effect on lowering the decrepitation tendency of dolomite. In order to confirm this result, a test is performed in a continuous industrial scale process.

Dolomite usually used in the glass industry is treated by a sodium hydroxide solution (NaOH) during its crushing. At the entrance of the crushing line, the dolomite particle size ranges between 0 and 80 mm. At the outlet, the particle sizes are measured to range between 0 and 3 mm. The sodium hydroxide solution is sprayed through nozzles on the raw 0-80 mm dolomite when falling into the crusher. Thus, the crushing is used as a mixing step to guarantee the proper contact between the solid and the liquid phase. The experimental conditions used for this trial are summarised in table 3.

**Table 3: Experimental conditions used during the industrial trial**

| Production rate of 0-3 mm dolomite | Trial duration | Total amount of treated 0-3 mm dolomite produced | NaOH ratio to the raw dolomite mass | NaOH solution concentration | NaOH solution flow rate |
|---|---|---|---|---|---|
| ~ 42 tons/hour | 12 hours | ~ 500 tons | 1 wt% | 50 wt% | ~ 850 kg/hour |

In contrast to examples 1 to 13, the entire fraction of crushed dolomite (0-3 mm samples) is treated and characterised (not only the 90-500 µm fraction). All the raw (non treated) and treated samples are prepared in a specific way (see below) before the decrepitation measurements with the Pilkington test. This is done taking into account the tight link between the decrepitation rate of dolomite samples and the 90-500 µm particle proportion contained.

Ten crushed dolomite blank samples (untreated dolomite) are analysed and their particle size distribution is determined by sieving with standard sieves (2 mm, 1 mm, 0.5 mm, 0.4 mm, 0.2 mm, 0.16 mm, 0.09 mm and 0.063 mm). For each blank sample, the proportion of the granulometric fraction (1-2 mm, 0.5-0.4 mm, ...) is noted and an average particle size distribution is calculated using the values obtained for the blanks studied.

Subsequently, the granulometry of the NaOH-treated samples is recomposed according to the average particle size distribution obtained. This procedure allows for a comparison of the raw and the treated samples in order to focus on the influence of the NaOH treatment only, excluding any effect of the particle size distribution.

With the average particle size distribution, the considered raw dolomite samples (not treated) have a decrepitation rate close to 6%. With the same particle size distribution, the samples treated according to the invention with 1% NaOH solution have a decrepitation rate ranging between 1.5 and 2%. These values correspond to a decrease of the decrepitation rate close to 70%.

### 4. Example 19: Determination of the average composition of dolomite treated according to the invention

The average composition of dolomite treated according to the invention is determined and compared to the average composition of untreated dolomite. The results are shown in Table 4.

**Table 4: Average composition of dolomite treated in the process according to the invention.**

| | Dolomite untreated | | Dolomite treated with NaOH | | Dolomite treated with KOH | | Dolomite treated with Na₂CO₃ | | Dolomite treated with K₂CO₃ | | Dolomite treated with Na₂SO₄ | | Dolomite treated with K₂SO₄ | | | | Dolomite treated with Sodium Silicate | |
|---|---|---|---|---|---|---|---|---|---|---|---|---|---|---|---|---|---|---|
| | - | | 0,05% | 5,00% | 0, 05% | 5,00% | 0,05% | 5,00% | 0,05% | 5,00% | 0,05% | 5,00% | 0,05% | 5,00% | | | 0,05% | 5,00% |
| | Min% | Max% | Min% | Max% | Min% | Max% | Min% | Max% | Min% | Max% | Min% | Max% | Min% | Max% | | | Min% | Max% |
| Ca | 20,0 | 24,3 | | | | | | | | | | | | | - | - | | |
| Mg | 10,9 | 14,1 | | | | | | | | | | | | | - | - | | |
| S | 0,004 | 0,06 | | | | | | | | | 0,01 | 1,13 | 0,01 | 0,92 | | | | |
| Si | 0,01 | 1,86 | | | | | | | | | | | | | - | - | 0,01 | 1,15 |
| Na | 0,01 | 0,03 | 0,03 | 2,87 | | | 0,02 | 2,17 | | | 0,02 | 1,62 | | | - | - | 0,02 | 1,89 |
| K | 0,01 | 0,07 | | | 0,03 | 3,48 | | | 0,03 | 2,75 | | | 0,02 | 2,24 | - | - | | |

## Claims

1. Process for the manufacture of a material on the basis of calcium carbonate and/or magnesium carbonate having a reduced decrepitation tendency, **characterized in that** a material on the basis of calcium carbonate and/or magnesium carbonate comprising 20 to 80 wt.% of particles having a primary particle size of more than 90 µm and less than 1 mm is coated with at least one additive selected among alkali metal compounds, and/or alkaline earth metal compounds in an amount of 0.05 to 5 wt.% based on the amount of the material on the basis of calcium carbonate and/or magnesium carbonate wherein the alkaline earth metal compounds have a solubility at 25°C in water of at least 0.5%.

2. Process according to claim 1, **characterized in that** the material is coated with the additive in an amount of 0.1 to 3 wt.% and in particular 0.5 to 1.5 wt.%, based on the amount of the material on the basis of calcium carbonate and/or magnesium carbonate.

3. Process according to claim 1 or 2, **characterized in that** the coating with the additive is conducted at a temperature of less than 100°C.

4. Process according to any of claims 1 to 3, **characterized in that** the material on the basis of calcium carbonate and/or magnesium carbonate comprises more than 85 wt.%, preferably more than 90 wt.%, calcium carbonate and/or magnesium carbonate.

5. Process according to any of claims 1 to 4, **characterized in that** dolomite and/or limestone is used as material on the basis of calcium carbonate and/or magnesium carbonate.

6. Process according to any of claims 1 to 5, **characterized in that** the material on the basis of calcium carbonate and/or magnesium carbonate is coated with sodium hydroxide (NaOH), sodium silicate (Na-silicate), sodium sulfate (Na₂SO₄) , sodium carbonate (Na₂CO₃), potassium carbonate (K₂CO₃), or magnesium sulfate (MgSO₄).

7. Process according to any of claims 1 to 6, **characterized in that** the material on the basis of calcium carbonate and/or magnesium carbonate is coated with a solution containing the additive and a solvent.

8. Process according to claim 7, **characterized in that** a solution containing the alkali metal compound and/or the alkaline earth metal compound in an amount of 0.5 to 60 wt.%, preferably 5 to 60 wt.%, most preferably 25 to 50 wt.% is used.

9. Process according to any of claims 1 to 8, **characterized in that** the material on the basis of calcium carbonate and/or magnesium carbonate is coated in the presence of SiO₂ in an amount of less than sixtimes the amount of the material on the basis of calcium carbonate and/or magnesium carbonate.

10. Material on the basis of calcium carbonate and/or magnesium carbonate having a reduced decrepitation tendency, manufacturable in a process according to any of claims 1 to 9.

11. Material according to claim 10, **characterized in that** the material comprises 20 wt.% to 80 wt.% of particles having a primary particle size of more than 150 *µ*m, and less than 500 *µ*m.

12. Material according to claim 10 or 11 **characterized in that** the material on the basis of calcium carbonate and/or magnesium carbonate comprises sulfur in an amount of 0.07 to 3 wt.%, preferably 0.1 to 2.5 wt.%, more preferably 0.15 to 2 wt.%, and in particular 0.2 to 1.7 wt.%, and/or sodium in an amount of 0.04 to 4.5 wt.%, preferably 0.05 to 4 wt.%, more preferably 0.08 to 3.5 wt.%, and in particular of 0.1 to 2.9 wt.%, and/or potassium in an amount of 0.08 to 5 wt.%, preferably 0.1 to 4.5 wt.%, more preferably 0.15 to 4 wt.%, and in particular 0.2 to 3.5 wt.%, based on the material of calcium carbonate and/or magnesium carbonate.

13. Use of a material according to any of claims 10 to 12 in the manufacture of glass.

## Patentansprüche

1. Verfahren zur Herstellung eines Materials auf der Basis von Calciumcarbonat und/oder Magnesiumcarbonat mit verringerter Dekrepitationsneigung, **dadurch gekennzeichnet, dass** ein Material auf der Basis von Calciumcarbonat und/oder Magnesiumcarbonat, das 20 bis 80 Gew.-% Teilchen mit einer primären Partikelgröße von mehr als 90 µm und weniger als 1 mm umfasst, mit mindestens einem Zusatzstoff, der aus Alkalimetallverbindungen und/oder Erdalkalimetallverbindungen ausgewählt ist mit einer Menge von 0,05 bis 5 Gew.-%, bezogen auf die Menge an Material auf der Basis von Calciumcarbonat und/oder Magnesiumcarbonat, beschichtet wird, wobei die Löslichkeit der Erdalkalimetallverbindungen in Wasser bei 25 °C mindestens 0,5 % beträgt.

2. Verfahren nach Anspruch 1, **dadurch gekennzeichnet, dass** das Material mit dem Zusatzstoff mit einem Menge von 0,1 bis 3 Gew.-% und insbesondere 0,5 bis 1,5 Gew.-%, bezogen auf die Menge an Material auf der Basis von Calciumcarbonat und/oder Magnesiumcarbonat, beschichtet wird.

3. Verfahren nach Anspruch 1 oder 2, **dadurch gekennzeichnet, dass** das Beschichten mit dem Zusatzstoff bei einer Temperatur von weniger als 100 °C durchgeführt wird.

4. Verfahren nach einem der Ansprüche 1 bis 3, **dadurch gekennzeichnet, dass** das Material auf der Basis von Calciumcarbonat und/oder Magnesiumcarbonat mehr als 85 Gew.-% und vorzugsweise mehr als 90 Gew.-% Calciumcarbonat und/oder Magnesiumcarbonat enthält.

5. Verfahren nach einem der Ansprüche 1 bis 4, **dadurch gekennzeichnet, dass** als Material auf der Basis von Calciumcarbonat und/oder Magnesiumcarbonat Dolomit und/oder Kalkstein verwendet wird.

6. Verfahren nach einem der Ansprüche 1 bis 5, **dadurch gekennzeichnet, dass** das Material auf der Basis von Calciumcarbonat und/oder Magnesiumcarbonat mit Natriumhydroxid (NaOH), Natriumsilicat (Na-Silicat), Natriumsulfat (Na₂SO₄), Natriumcarbonat (Na₂CO₃), Kaliumcarbonat (K₂CO₃) oder Magnesiumsulfat (MgSO₄) beschichtet wird.

7. Verfahren nach einem der Ansprüche 1 bis 6, **dadurch gekennzeichnet, dass** das Material auf der Basis von Calciumcarbonat und/oder Magnesiumcarbonat mit einer Lösung, die den Zusatzstoff und ein Lösungsmittel enthält, beschichtet wird.

8. Verfahren nach Anspruch 7, **dadurch gekennzeichnet, dass** eine Lösung, welche die Alkalimetallverbindung und/oder die Erdalkalimetallverbindung in einer Menge von 0,5 bis 60 Gew.-%, vorzugsweise 5 bis 60 Gew.-%, und am meisten bevorzugt 25 bis 50 Gew.-% enthält, verwendet wird.

9. Verfahren nach einem der Ansprüche 1 bis 8, **dadurch gekennzeichnet, dass** das Material auf der Basis von Calciumcarbonat und/oder Magnesiumcarbonat in Gegenwart von SiO₂ in einer Menge von weniger als dem Sechsfachen der Menge des Materials auf der Basis von Calciumcarbonat und/oder Magnesiumcarbonat beschichtet wird.

10. Material auf der Basis von Calciumcarbonat und/oder Magnesiumcarbonat mit verringerter Dekrepitationsneigung, das durch ein Verfahren nach einem der Ansprüche 1 bis 9 herstellbar ist.

11. Material nach Anspruch 10, **dadurch gekennzeichnet, dass** das Material 20 Gew.-% bis 80 Gew.-% Teilchen mit einer primären Partikelgröße von mehr als 150 µm und weniger als 500 µm umfasst.

12. Material nach Anspruch 10 oder 11, **dadurch gekennzeichnet, dass** das Material auf der Basis von Calciumcarbonat und/oder Magnesiumcarbonat Schwefel in einer Menge von 0,07 bis 3 Gew.-%, vorzugsweise 0,1 bis 2,5 Gew.-%, besonders bevorzugt 0,15 bis 2 Gew.-%, und insbesondere 0,2 bis 1,7 Gew.-% und/oder Natrium in einer Menge von 0,04 bis 4,5 Gew.-%, vorzugsweise 0,05 bis 4 Gew.-%, besonders bevorzugt 0,08 bis 3,5 Gew.-%, und insbesondere 0,1 bis 2,9 Gew.-% und/oder Kalium in einer Menge von 0,08 bis 5 Gew.-%, vorzugsweise 0,1 bis 4,5 Gew.-%, besonders bevorzugt 0,15 bis 4 Gew.-%, und insbesondere 0,2 bis 3,5 Gew.-%, bezogen auf das Material aus Calciumcarbonat und/oder Magnesiumcarbonat, enthält.

13. Verwendung des Materials nach einem der Ansprüche 10 bis 12 für die Herstellung von Glas.

## Revendications

1. Procédé de fabrication d'un matériau à base de carbonate de calcium et/ou de carbonate de magnésium, ayant une tendance réduite à la décrépitation, **caractérisé en ce qu'**un matériau à base de carbonate de calcium et/ou de carbonate de magnésium comprenant 20 à 80 % en poids de particules ayant une taille de particules primaires supérieure à 90 µm et inférieure à 1 mm est recouvert d'au moins un additif choisi parmi des composés de métaux alcalins et/ou des composés de métaux alcalino-terreux, en une quantité de 0,05 à 5 % en poids, par rapport à la quantité du matériau à base de carbonate de calcium et/ou de carbonate de magnésium, dans lequel les composés de métaux alcalino-terreux ont une solubilité à 25 °C dans l'eau d'au moins 0,5 %.

2. Procédé selon la revendication 1, **caractérisé en ce que** le matériau est recouvert de l'additif en une quantité de 0,1 à 3 % en poids, et en particulier de 0,5 à 1,5 % en poids, par rapport à la quantité du matériau à base de carbonate de calcium et/ou de carbonate de magnésium.

3. Procédé selon la revendication 1 ou 2, **caractérisé en ce que** l'enrobage avec l'additif est réalisé à une température inférieure à 100 °C.

4. Procédé selon l'une quelconque des revendications 1 à 3, **caractérisé en ce que** le matériau à base de carbonate de calcium et/ou de carbonate de magnésium comprend plus de 85 % en poids, de préférence plus de 90 % en poids, de carbonate de calcium et/ou de carbonate de magnésium.

5. Procédé selon l'une quelconque des revendications 1 à 4, **caractérisé en ce que** de la dolomie et/ou du calcaire est utilisé(e) comme matériau à base de carbonate de calcium et/ou de carbonate de magnésium.

6. Procédé selon l'une quelconque des revendications 1 à 5, **caractérisé en ce que** le matériau à base de carbonate de calcium et/ou de carbonate de magnésium est recouvert d'hydroxyde de sodium (NaOH), de silicate de sodium (silicate de Na), de sulfate de sodium (Na₂SO₄), de carbonate de sodium (Na₂CO₃), de carbonate de potassium (K₂CO₃) ou de sulfate de magnésium (MgSO₄).

7. Procédé selon l'une quelconque des revendications 1 à 6, **caractérisé en ce que** le matériau à base de carbonate de calcium et/ou de carbonate de magnésium est recouvert d'une solution contenant l'additif et un solvant.

8. Procédé selon la revendication 7, **caractérisé en ce qu'**une solution contenant le composé de métal alcalin et/ou le composé de métal alcalino-terreux en une quantité de 0,5 à 60 % en poids, de préférence de 5 à 60 % en poids, plus préférablement de 25 à 50 % en poids, est utilisée.

9. Procédé selon l'une quelconque des revendications 1 à 8, **caractérisé en ce que** le matériau à base de carbonate de calcium et/ou de carbonate de magnésium est recouvert en présence de SiO₂ en une quantité inférieure à six fois la quantité du matériau à base de carbonate de calcium et/ou de carbonate de magnésium.

10. Matériau à base de carbonate de calcium et/ou de carbonate de magnésium ayant une tendance réduite à la décrépitation, pouvant être fabriqué dans un procédé selon l'une quelconque des revendications 1 à 9.

11. Matériau selon la revendication 10, **caractérisé en ce que** le matériau comprend 20 % à 80 % en poids de particules ayant une taille de particules primaires supérieure à 150 µm et inférieure à 500 µm.

12. Matériau selon la revendication 10 ou 11, **caractérisé en ce que** le matériau à base de carbonate de calcium et/ou de carbonate de magnésium comprend du soufre en une quantité de 0,07 à 3 % en poids, de préférence de 0,1 à 2,5 % en poids, plus préférablement de 0,15 à 2 % en poids, et en particulier de 0,2 à 1,7 % en poids, et/ou du sodium en une quantité de 0,04 à 4,5 % en poids, de préférence de 0,05 à 4 % en poids, plus préférablement de 0,08 à 3,5 % en poids, et en particulier de 0,1 à 2,9 % en poids, et/ou du potassium en une quantité de 0,08 à 5 % en poids, de préférence de 0,1 à 4,5 % en poids, plus préférablement de 0,15 à 4 % en poids, et en particulier de 0,2 à 3,5 % en poids, par rapport au matériau à base de carbonate de calcium et/ou de carbonate de magnésium.

13. Utilisation d'un matériau selon l'une quelconque des revendications 10 à 12, dans la fabrication de verre.
